# EUROPÄISCHE PATENTSCHRIFT

(11) **EP 0 746 193 B1**
(45) Veröffentlichungstag und Bekanntmachung des Hinweises auf die Patenterteilung: **11.02.1998**
(21) Anmeldenummer: 96105875.7
(22) Anmeldetag: 15.04.1996
(51) Int. Cl.: H05K 9/00

(54) **Kontaktfederleiste zum Aufstecken auf Halteleisten insbesondere an den Frontplatten der Baugruppen von abgeschirmten Baugruppenträgern**
Spring contact strip for mounting on an support which can be the front panel of a shielded rack module
Bande ressort de contact à mettre sur un support qui peut être la face avant d'un module d'une baie blindée

(30) Priorität: 01.06.1995 DE 29509102 U
(43) Veröffentlichungstag der Anmeldung: 04.12.1996
(73) Patentinhaber: SIEMENS AKTIENGESELLSCHAFT, 80333 München (DE)
(72) Erfinder: Billenstein, Ernst, 91593 Burgbernhein (DE); Körber, Werner, 91282 Betzenstein (DE); Kurrer, Siegfried, 90449 Nürnberg (DE); Schaffer, Kurt-Michael, 90542 Eckental (DE)

(56) Entgegenhaltungen:
- EP-A- 0 207 226
- EP-A- 0 456 858
- DE-C- 4 110 800
- DE-C- 4 311 246
- US-A- 2 065 651

## Beschreibung

Aus der DE 41 10 800 C1 ist eine "Baugruppe zum Einschub in HF-dichte Gehäuse elektronischer Geräte" bekannt. Die Baugruppe weist eine im Profil U-förmig ausgebildete Frontplatte auf. Zur hochfrequenzmäßigen Abdichtung der Längsspalten zwischen den Frontplatten von parallel nebeneinander z.B. in einem Baugruppenträger angeordneten Baugruppen ist eine aus einer Vielzahl von kettenartig folgenden Federelementen bestehende Federleiste vorgesehen. Diese ist auf dem die eine Seite des U-förmigen Profils der Frontplatte einer Baugruppe bildenden Längssteg aufgesteckt und kontaktiert diese Frontplatte elektromagnetisch und hochfrequenzdicht mit der gegenüberliegenden, die andere Seite des U-förmigen Profils der Frontplatte einer benachbarten Baugruppe bildenden Längsleiste.

Ein Federelement der Federleiste besteht aus zwei gleich ausgebildeten Kontaktfedern mit je einem Federblatt sowie einer dazwischen angeordneten Federklemme mit einem Klemmblatt. Die Kontaktfedern und die Federklemme haben ein gemeinsames, ebenes Ruckseitenblatt. Federklemme und Ruckseitenblatt sind im Querschnitt U-förmig ausgebildet und auf den Längssteg der Frontplatte klemmend so aufschiebbar, daß das Rückseitenblatt an der Innenseite des Längssteges aufliegt. Kontaktfedern und Ruckseitenblatt haben V-förmigen Querschnitt, so daß deren Federblätter von der Außenseite des Längssteges abgespreizt sind.

Ein Problem bei dieser Anordnung wird darin gesehen, daß für eine ordnungsgemäße und ausreichende Klemmwirkung die zusammenwirkenden Elemente Federklemme und Rückseitenblatt und der Längssteg, auf den diese Elemente aufgeschoben werden, eine ausreichende Höhe aufweisen müssen. Diese hat seine Ursache im wesentlichen darin, daß die Haltewirkung überwiegend durch Ausnutzung von Reibungskräften erzielt wird. Ein weiteres, damit zusammenhängendes Problem wird darin gesehen, daß das Element Federklemme auf der Vorderseite des Federelementes ferner eine ausreichende Breite aufweisen muß, um die notwendige Klemmwirkung zu erzielen. Hierdurch bedingt ist der Abstand zwischen den beidseitig der Federklemme angeordneten Kontaktfedern relativ groß. Zur Erzielung einer durchgehenden Kontaktierung und somit ausreichenden Schirmwirkung ist es notwendig, daß die Federblätter durch eine Verbindungsbrücke im unteren Bereich miteinander verbunden sind. Da diese Verbindungsbrücke aber wegen der dazwischen liegenden, hohen Federklemme nur schmal und stegartig ausführbar ist, besteht leicht die Gefahr einer mechanischen Beschädigung derselben.

Der Erfindung liegt somit die Aufgabe zugrunde, eine Kontaktfederleiste anzugeben, womit insbesondere die oben aufgeführten Nachteile vermieden werden.

Die Aufgabe wird gelost mit der im Anspruch 1 angegebenen Kontaktfederleiste. Vorteilhafte weitere Ausführungsformen der Erfindung sind in den Unteransprüchen angegeben.

Die Erfindung und die damit verbundenen Vorteile werden mit den in den nachfolgend kurz angeführten Figuren dargestellten Beispielen nachfolgend naher erläutert. Dabei zeigt
- Fig.1.: eine Schnittdarstellung durch eine erste Ausführungsform einer auf einer Halteleiste aufgerasteten erfindungsgemäßen Kontaktfederleiste,
- Fig.2.: eine perspektivische Seitenansicht auf die Vorderseite von zwei kettenartig zusammenhängenden Kontaktfedern gemäß einer zweiten Ausführungsform, welche einen Ausschnitt aus einer Kontaktfederleiste darstellen,
- Fig.3.: eine perspektivische Seitenansicht auf die Rückseite der zwei kettenartig zusammenhängenden Kontaktfedern gemaß Fig.2,
- Fig.4.: eine perspektivische Seitenansicht auf die Vorderseite von zwei kettenartig zusammenhängenden Kontaktfedern, welche im wesentlichen der in Figur 2 dargestellten Ausführungsform entsprechen, aber über biberschwanzartig verbreiterte Federblätter verfügen, und
- Fig.5.: eine im wesentlichen der Ausführung gemaß der Figuren 2 bis 4 entsprechende Schnittdarstellung einer auf einen Seitensteg der Frontplatte einer Flachbaugruppe aufgerasteten Kontaktfederleiste gemaß der Erfindung.

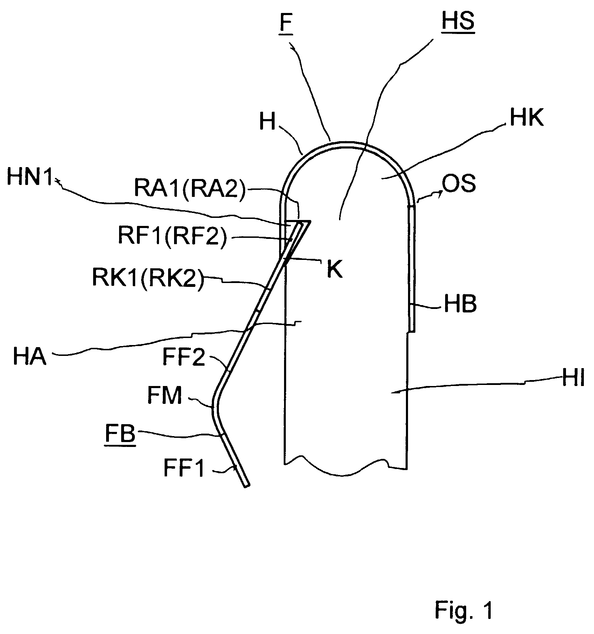

In der Schnittdarstellung gemäß Figur 1 ist der obere Bereich einer Halteleiste HS dargestellt, welche als Träger für eine aufgerastete Kontaktfederleiste gemaß der Erfindung dient. Die Halteleiste weist eine Vorderseite HA und eine Rückseite HI auf. Auf der als Kontaktbereich dienenden Vorderseite HA kommen die Federblätter FB der Kontaktfedern F der Kontaktfederleiste zu liegen, während die Rückseite HI quasi als Widerlager zur Halterung der Kontaktfeder dient.

Ein Hutbereich H der Kontaktfeder F umfaßt den Kopfbereich HK der Halteleiste HS und liegt dort möglichst formschlüssig auf. Im dargestellten Beispiel ist der Kopfbereich HK abgerundet, so daß der formmäßig angepaßte Hutbereich bei dieser Ausführung im Querschnitt umgekehrt u- bzw. rinnenförmig ist. Bei einer anderen, nicht dargestellten Ausführung ist es auch möglich, daß der Kopfbereich HK rechteckfömig und kantig gestaltet ist, so daß dann der Hutbereich H der Kontaktfederleiste umgekehrt schachtfömig ist.

Erfindungsgemäß ist ein Federblatt FB, worüber bei Berührung mit gegenüberliegenden, zum Zwecke der besseren Übersicht in Figur 1 nicht dargestellten Bauteilen eine elektrisch leitende Kontaktierung bewirkt wird, ausgehend von einer Knickkante K vom Hutbereich H nach außen abgespreizt. Das Federblatt FB der Kontaktfeder weist bevorzugt einen dachförmigen Querschnitt auf. Es ergibt sich in diesem Fall eine Federflanke FF2, welche von der Knickkante K bis zu einer am weitesten von der Vorderseite HA der Halteleiste HS abstehenden Federmitte FM verläuft. Ferner ergibt sich im Anschluß daran eine weitere Federflanke FF1, welche von der Federmitte FM aus wieder auf die Vorderseite HA gerichtet verläuft.

Die Kontaktfeder gemäß der Erfindung verfügt ferner über zwei Rastkrallen RK1 und RK2, welche vom Hutbereich H ausgehend auf der Vorderseite HA der Halteleiste HS an der Knickkante K in annähernd der gleichen Weise wie das Federblatt FB nach außen abgespreizt und beidseitig neben dem Federblatt FB liegend freigeschnitten sind. In der seitlichen Querschnittsdarstellung von Figur 1 ist die vordere Rastkralle RK1 zu sehen, während die andere Rastkralle RK2 in der Zeichenebene liegt. Aus diesem Grund sind die zur Rastkralle RK2 gehörenden Bezugszeichen in Figur 1 in Klammern gesetzt. Erfindungsgemäß weist jede Rastkralle RK1,RK2 eine nach oben in Richtung auf den Kopfbereich HK und die Vorderseite HA der Halteleiste HS abgespreizt Haltefahne RF1,RF2 auf, die ganz oben in einer Rastkante RA1,RA2 endet. Die Haltefahnen RF1,RF2 können gemäß der Darstellung in Figur 1 im aufgesteckten Zustand der Kontaktfeder (F) vorteilhaft in eine Rastnut HN1 eingreifen, welche auf der Vorderseite HA annähernd unterhalb des Kopfbereiches HK in die Halteleiste HS eingebracht ist, und werden darin über die Rastkanten RA1,RA2 abgestützt.

Gemäß einer anderen, nicht dargestellten Ausführungsform ist es auch möglich, auf eine Rastnut in der Halteleiste HS zu verzichten, so daß die Rastkanten RA1,RA2 klemmend und u.U. bis zu einem gewissen Grad auch schneidend unmittelbar auf die Fläche der Vorderseite HA der Halteleiste HS eingreifen.

Schließlich weist die erfindungsgemäße Kontaktfeder F noch ein Halteblatt HB auf, welches vom Hutbereich H ausgehend auf die Rückseite HI der Halteleiste HS reicht. Die Kontaktfeder F liegt dabei eben klemmend auf der Rückseite HI der Halteleiste HS an.

Die erfindungsgemäße Ausführung weist den besonderen Vorteil auf, daß die Verrastung der Kontaktfeder F mit der Halteleiste HS im wesentlichen annähernd unterhalb von deren Kopfbereiches HK erfolgt. Das abgespreizte Federblatt FB der Kontaktfeder ist somit nahezu vollständig entkoppelt von haltenden Rastkrallen RK1 und RK2.

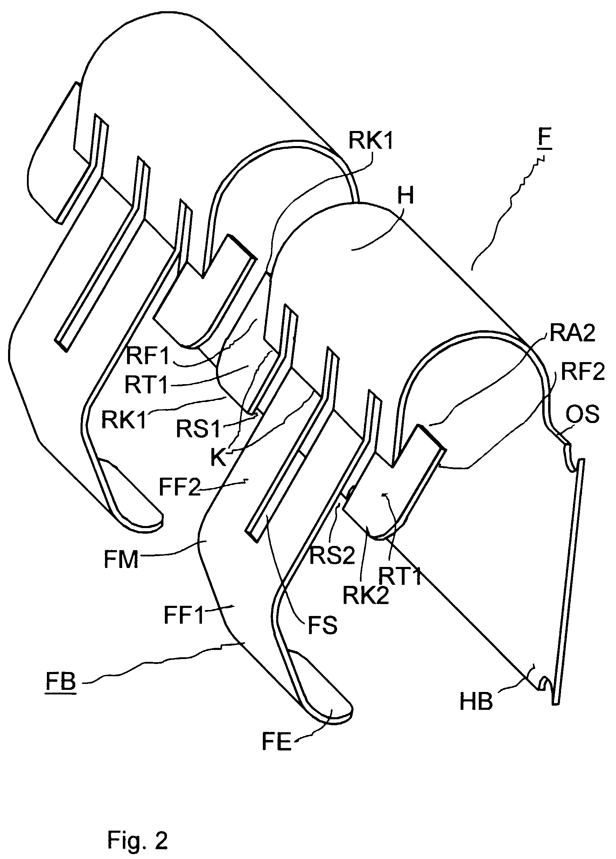

Der Vorteil dieser Ausgestaltung ist in Figur 2 besonders deutlich zu erkennen, welche eine perspektivische Draufsicht auf die Vorderseite von zwei, kettenartig zusammenhängenden Kontaktfedern F zeigt. Eine sehr große Vielzahl von derartigen Kontaktfedern kann zu einer Kontaktfederleiste verbunden sein.

Die Kontaktfeder F ist beidseitig über je einen Freischnitt bzw. Schlitz RS1 und RS2 von den benachbarten Rastkrallen RK1 und RK2 freigeschnitten. Jede der beiden Rastkrallen verfügt über je eine Tragfläche RT1,RT2, die in fertigungstechnisch günstiger Weise wie das dazwischen liegende Federblatt FB an der Knickkante K vom Hutbereich H nach vorne abgespreizt sind. Hierdurch bedingt sind die oberhalb der Kickkante K nach hinten abgehenden fahnenförmigen Verlängerungen RF1,RF2, desweiteren Haltefahnen genannt, umgekehrt in Richtung auf die Vorderseite der Halteleiste abgespreizt und können über deren Rastkanten RA1,RA2 an den oberen Enden der Rastfahnen RF1,RF2 optimal in eine entsprechende Rastnut der Halteleiste einrasten. Aufgrund der erfindungsgemäßen Gestaltung sind das Federblatt FB und die beidseitigen Rastkrallen RK1,RK2 somit funktionell optimal voneinander entkoppelt. Vorteilhaft können hierzu die Freischnitte RS1,RS2 nach oben über die Knickkante K hinaus bis in den Hutbereich H hinein verlängert werden.

Bei der in Figur 2 dargestellten Ausführung ist das auf der Rückseite der Halteleiste aufliegende Halteblatt HB verlängert ausgeführt. Hierdurch kann die Halterung der Kontaktfeder F an der Halteleiste insbesondere bei Auftreten von besonders starken, insbesondere auf die Federmitte FM einwirkenden Schub-, Verformungs- und Reibkräften verbessert werden.

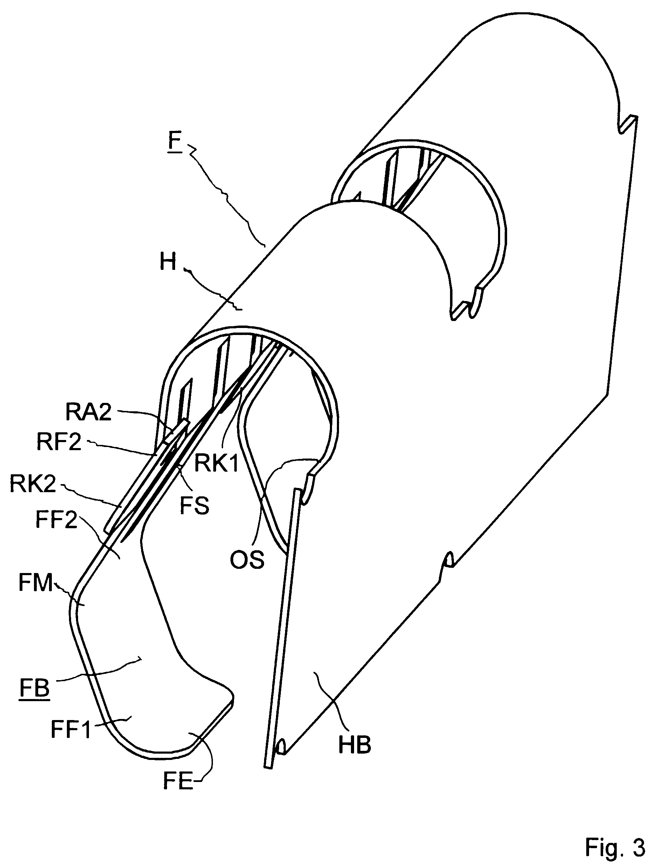

Gemaß einer weiteren, in den Figuren 2 und 3 bereits dargestellten Ausführung weist das Federblatt FB selbst einen Längsschlitz FS auf. Hierdurch wird die Feder "weicher" und kann sich somit leichter elastisch verformen auf Grund von schräg tangential insbesondere auf die zweite Federflanke FF2 auftreffenden Druck- und Reibkräfte beim Kontaktiervorgang mit gegenüber liegenden Kontaktflachen, welche bevorzugt Bestandteil der Seite einer benachbarten Frontplatte einer weiteren Baugruppe sind.

Vorteilhaft ist die untere, den eingreifenden Kräften abgewandte erste Federflanke FF1, welche von der Federmitte FM bis zum Federende FE verläuft, massiv gefüllt. Hierdurch hat diese erste Federflanke FF1 eine ausreichende innere Steifigkeit gegen Verwindungen. Insbesondere verläuft der Längsschlitz FS lediglich entlang der zweiten Federflanke FF2, d.h. zumindest etwa von der Federmitte FM bis zur Knicklinie. Es wird somit nur diejenige Federflanke "weicher", welche bei einem Kontaktiervorgang besonders starken Verformungen ausgesetzt ist. Desweiteren kann der Längsschlitz FS aber auch über die Federmitte FM hinaus bis in die erste Federflanke FF1 reichen. Dies beeinflußt vorteilhaft neben den Federeigenschaften auch die Kontakteigenschaften der auf Hohe der Federmitte FM liegenden Kontaktfläche der Kontaktfläche F. Reicht der Längsschlitz FS gemäß der Darstellung in Figur 2 nach oben über die Knickkante K hinaus bis in den Hutbereich H, so wird die zerstörungsfreie Verformbarkeit der Kontaktfeder F weiter gefördert. Generell kann durch entsprechende Wahl der Breite des Längsschlitzes FS und der Breiten der beiden rechts bis zum Freischlitz RS1 und links bis zum Freischlitz RS2 reichenden Stege des Federblattes FB dessen Federcharakteristik eingestellt werden.

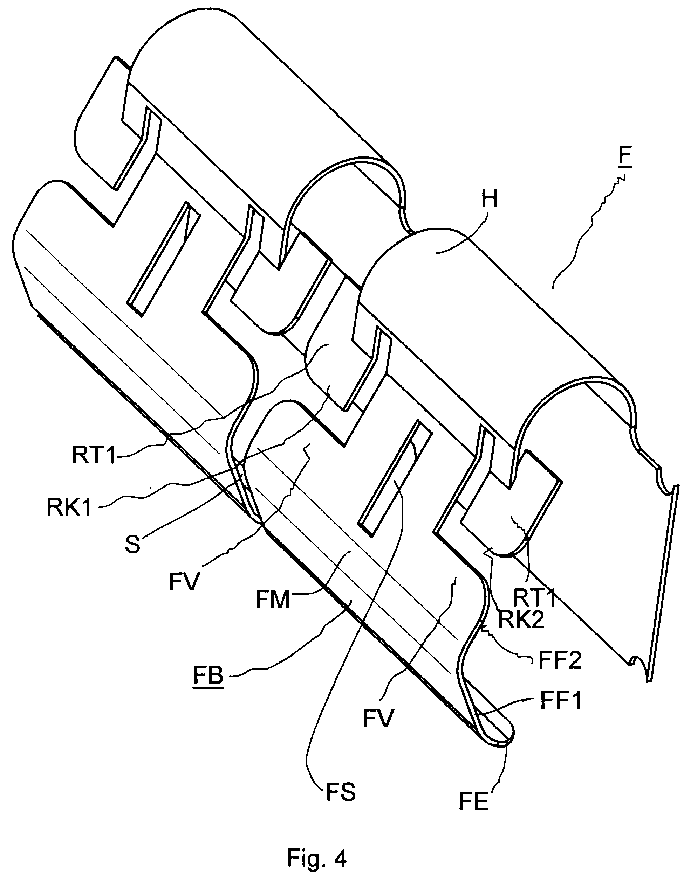

Figur 4 zeigt eine weitere perspektivische Seitenansicht auf die Vorderseite von beispielhaft zwei kettenartig zusammenhängenden Kontaktfedern. Diese entsprechen zwar im wesentlichen der in Figur 2 dargestellten Ausführungsform, verfügen aber über biberschwanzartig verbreiterte Federblätter. So ist die Fläche des Federblattes FB sowohl auf der linken als auch auf der rechten Seite durch Verbreiterungen FV so vergrößert, daß die Federblätter benachbarter Kontaktfedern nur noch über einen schmalen Spalt S voneinander getrennt sind. Wie in Figur 4 bereits dargestellt, entsprechen die Breiten der Verbreiterungen FV besonders vorteilhaft annähernd den Breiten der in Richtung auf den Hutbereich H darüber liegend angeordneten Rastkrallen RK1,RK2. Es sind somit im Vergleich zur Ausführung von Figur 2 im Beispiel der Figur 4 beidseitig der Federmitte FM eines Federblattes FB jeweils die Bereiche der ersten und zweiten Federflanke FF1,FF2 in Richtung der Erstreckung einer aus einer Vielzahl von kettenartig zusammenhängenden Kontaktfedern F bestehenden Kontaktfederleiste verlängert. Die Federmitten FM von derart zu einer Kontaktfederleiste zusammengefaßten Kontaktfedern bilden somit einen nahezu durchgehenden Auflagebereich für gegenüberliegende Bauteile inbesondere von benachbarten Flachbaugruppen und sind somit nur noch durch den schmalen Spalt S bzw. den Längsschlitz FS voneinander getrennt.

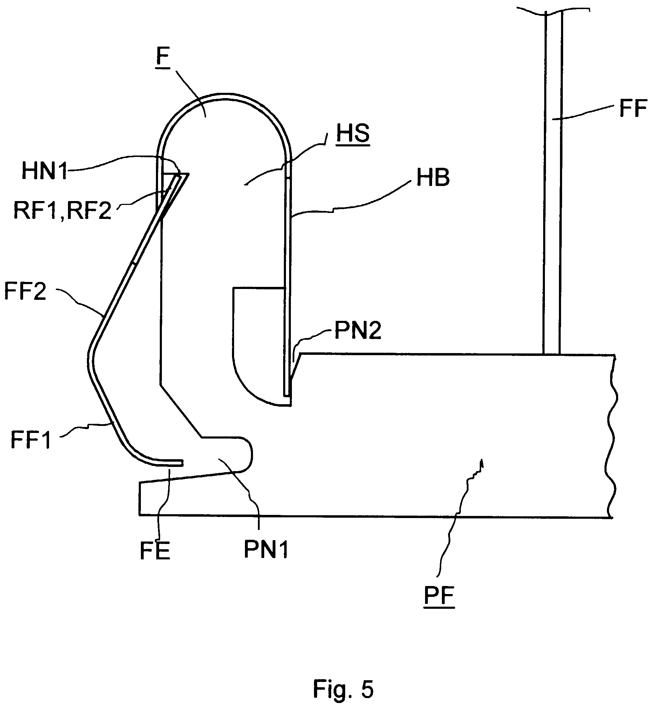

Bevorzugt bildet das Federende FE eine stark nach innen gerichtete Abknickung des Federblattes FB. Dies ist insbesondere dann von Vorteil, wenn die erfindungsgemäße Kontaktfeder bzw. eine daraus gebildete Kontaktfederleiste auf eine Halteleiste aufgerastet wird, welche ein Seitenteil der Frontplatte einer Flachbaugruppe darstellt. Eine solche Verwendung ist im Beispiel der Figur 5 dargestellt. Bei Flachbaugruppen ist damit zu rechnen, daß diese häufiger aus einem Baugruppenträger entnommen und wieder eingesteckt werden. Es können somit wiederholt starke Verfomungskräfte in schräg tangentialer Richtung von unten auch auf die zweite Federflanke FF1 einwirken. Zur Vermeidung von irreversiblen Verformungen und gegebenenfalls sogar Verklemmungen ist es vorteilhaft, wenn das untere Federende FE stark nach innen abgeknickt ist.

Figur 5 zeigt das linke Ende der Frontplatte PF einer Flachbaugruppe FF. Parallel zur Flachbaugruppe erstreckt sich eine Halteleiste HS, auf die eine gemäß der Erfindung gestaltete Kontaktfeder F aufgerastet ist. Es ist deutlich zu erkennen, daß auf Grund der Verrastung der Kontaktfeder zumindest mit der Vorderseite der Halteleiste HS in deren Kopfbereich sowohl die tragende Halteleiste als auch die Kontaktfeder nur eine geringe Bauhöhe aufzuweisen brauchen. Vorteilhaft verfügt die Frontplatte PF in Figur 5 seitlich über eine erste Eingriffsnut PN1, in die das Federende FE der Kontaktfeder F eintauchen kann. Vorteilhaft ist eine zweite Eingriffsnut PN2 im Achselbereich zwischen der Innenseite der Frontplatte PF und der Rückseite der Halteleiste HS vorhanden. Diese kann insbesondere zur Aufnahme des unteren Ende eines Halteblattes HB und somit zu einer seitlichen Abstützung der Kontaktfeder F dienen.

## Patentansprüche

1. Kontaktfederleiste aus einer Vielzahl von kettenartig zusammenhängenden Kontaktfedern (F), zum Aufstecken auf eine Halteleiste (HS) insbesondere an der Frontplatte (PF) einer Flachbaugruppe, wobei jede Kontaktfeder (F) enthält
a) einen Hutbereich (H), welcher im aufgesteckten Zustand der Kontaktfederleiste den Kopfbereich (HK) der Halteleiste (HS) umfaßt,
b) ein Federblatt (FB), welches vom Hutbereich (H) auf der Vorderseite (HA) der Halteleiste (HS) ausgehend an einer Knickkante (K) nach außen abgespreizt ist,
c) zwei Rastkrallen (RK1,RK2), welche
c1) vom Hutbereich (H) ausgehend auf der Vorderseite (HA) der Halteleiste (HS) an der Knickkante (K) nach außen abgespreizt und beidseitig neben dem Federblatt (FB) liegend freigeschnitten sind, und
c2) die jeweils eine nach oben in Richtung auf den Kopfbereich (HK) und die Vorderseite (HA) der Halteleiste (HS) abgespreizte Haltefahne (RF1,RF2) mit einer Rastkante (RA1,RA2) aufweisen, und
d) ein Halteblatt (HB), welches vom Hutbereich (H) ausgehend auf die Rückseite (HI) der Halteleiste (HS) reicht.

2. Vorrichtung nach Anspruch 1, wobei die Freischnitte (RS1,RS2) der Rastkrallen (RK1,RK2) über die Knickkante (K) hinaus bis in den Hutbereich (H) reichen.

3. Vorrichtung nach Anspruch 1 oder 2, wobei das Federblatt (FB) einen Längsschlitz (FS) aufweist.

4. Vorrichtung nach Anspruch 1 oder 2, wobei das Federblatt (FB) bei annähernd dachförmigem Querschnitt (FF1,FM,FF2) eine erste, von der Federmitte (FM) bis zum Federende (FE) verlaufende Federflanke (FF1) und eine zweite, von der Federmitte (FM) bis zur Knickkante (K) verlaufende Federflanke (FF2) aufweist.

5. Vorrichtung nach Anspruch 4, wobei das Federblatt (FB) wenigstens in der auf den Hutbereich (H) zulaufenden Federflanke (FF2) einen Längsschlitz (FS) aufweist.

6. Vorrichtung nach einem der Ansprüche 3 bis 5, wobei der Längsschlitz (FS) wenigstens bis annähernd an die Knickkante (K) reicht.

7. Vorrichtung nach einem der Ansprüche 3 bis 6, wobei der Längsschlitz (FS) über die Federmitte (FM) hinaus bis in die erste Federflanke (FF1) reicht.

8. Vorrichtung nach einem der vorangegangenen Ansprüche, wobei die Rastkanten (RA1,RA2) der nach oben in Richtung auf den Kopfbereich (HK) und die Vorderseite (HA) der Halteleiste (HS) abgespreizten Haltefahnen (RF1,RF2) in eine Rastnut (HN1) auf der Vorderseite (HA) der Halteleiste (HS) eingreifen.

9. Vorrichtung nach einem der vorangegangenen Ansprüche, wobei das Federblatt (FB) beidseitig biberschwanzartige Verbreiterungen (FV) aufweist.

10. Vorrichtung nach Anspruch 9, wobei die Breiten der biberschwanzartigen Verbreiterungen (FV) des Federblatts (FB) annähernd den Breiten der in Richtung auf den Hutbereich (H) darüber liegend angeordneten Rastkrallen (RK1,RK2) entsprechen.

## Claims

1. Spring contact strip consisting of a plurality of contact springs (F) joined together in the form of a chain, for mounting on a retaining strip (HS), in particular at the front panel (PF) of a flat module, wherein each contact spring (F) comprises
a) a cap region (H) which, when the spring contact strip is in the mounted state, embraces the head region (HK) of the retaining strip (HS),
b) a spring leaf (FB) which, starting from the cap region (H) at the front (HA) of the retaining strip (HS), is urged outwards at a bending edge (K),
c) two locking claws (RK1, RK2) which,
c1) starting from the cap region (H), are urged outwards at the front (HA) of the retaining strip (HS) at the bending edge (K) and cut away so as to lie next to the spring leaf (FB) on both sides, and
c2) each of which comprises a retaining lug (RF1, RF2), which is urged upwards in the direction of the head region (HK) and the front (HA) of the retaining strip (HS), with a locking edge (RA1, RA2), and
d) a retaining leaf (HB) which, starting from the cap region (H), extends to the rear (HI) of the retaining strip (HS).

2. Device according to claim 1, wherein the cutouts (RS1, RS2) of the locking claws (RK1, RK2) extend beyond the bending edge (K) into the cap region (H).

3. Device according to claim 1 or 2, wherein the spring leaf (FB) comprises an elongate slot (FS).

4. Device according to claim 1 or 2, wherein, with an approximately roof-shaped cross section (FF1, FM, FF2), the spring leaf (FB) comprises a first spring flank (FF1) extending from the spring centre (FM) to the spring end (FE) and a second spring flank (FF2) extending from the spring centre (FM) to the bending edge (K).

5. Device according to claim 4, wherein the spring leaf (FB) comprises an elongate slot (FS), at least in the spring flank (FF2) leading up to the cap region (H).

6. Device according to one of claims 3 to 5, wherein the elongate slot (FS) extends at least approximately up to the bending edge (K).

7. Device according to one of claims 3 to 6, wherein the elongate slot (FS) extends beyond the spring centre (FM) into the first spring flank (FF1).

8. Device according to one of the preceding claims, wherein the locking edges (RA1, RA2) of the retaining lugs (RF1, RF2), which are urged upwards in the direction of the head region (HK) and the front (HA) of the retaining strip (HS), engage in a locking groove (HN1) at the front (HA) of the retaining strip (HS).

9. Device according to one of the preceding claims, wherein the spring leaf (FB) comprises widened portions (FV) like plain tiles on both sides.

10. Device according to claim 9, wherein the widths of the plain tile-like widened portions (FV) of the spring leaf (FB) correspond approximately to the widths of the locking claws (RK1, RK2) lying above in the direction of the cap region (H).

## Revendications

1. Réglette à ressorts de contact, constituée d'une pluralité de ressorts de contact (F) qui sont reliés entre eux comme une chaîne, destinée à être enfilée sur une réglette de support (HS), notamment au niveau du flan frontal (PF) d'un module plat, chaque ressort de contact (F) comportant
a) une zone de chapeau (H) qui entoure la zone de tête (HK) de la réglette de support (HS) lorsque la réglette à ressorts de contact est enfilée,
b) une lame de ressort (FB), qui part de la zone de chapeau (H) et est écartée vers l'extérieur sur la face avant (HA) de la réglette de support (HS) au niveau d'un bord de pliage (K),
c) deux griffes d'encliquetage (RK1, RK2), qui
c1) partent de la zone de chapeau (H) et sont écartées vers l'extérieur sur la face avant (HA) de la réglette de support (HS) au niveau du bord de pliage (K), et qui sont dégagées par découpe en étant situées des deux côtés de la lame de ressort (FB), et
c2) comportent chacune une barrette de retenue (RF1, RF2) ayant une arête d'encliquetage (RA1, RA2), laquelle est écartée vers le haut en direction de la zone de tête (HK) et de la face avant (HA) de la réglette de support (HS), et
d) une lame de retenue (HB) qui part de la zone de chapeau (H) et s'étend jusqu'à la face arrière (HI) de la réglette de support (HS).

2. Dispositif selon la revendication 1, dans lequel les découpes de dégagement (RS1, RS2) des griffes d'encliquetage (RK1,RK2) s'étendent au-delà du bord de pliage (K) jusque dans la zone de chapeau (H).

3. Dispositif selon la revendication 1 ou 2, dans lequel la lame de ressort (FB) comporte une fente longitudinale (FS).

4. Dispositif selon la revendication 1 ou 2, dans lequel la lame de ressort (FB) ayant approximativement une section transversale en forme de toit (FF1, FM, FF2), comporte un premier flan (FF1) de ressort qui s'étend du milieu (FM) du ressort jusqu'à l'extrémité (FE) du ressort, et un deuxième flan (FF2) de ressort qui s'étend du milieu (FM) du ressort jusqu'au bord de pliage (K).

5. Dispositif selon la revendication 4, dans lequel la lame de ressort (FB) comporte une fente longitudinale (FS), au moins dans le flan (FF2) du ressort qui s'étend vers la zone de chapeau (H).

6. Dispositif selon l'une quelconque des revendications 3 à 5, dans lequel la fente longitudinale (FS) s'étend, au moins approximativement, jusqu'au bord de pliage (K).

7. Dispositif selon l'une quelconque des revendications 3 à 6, dans lequel la fente longitudinale (FS) s'étend au-delà du milieu (FM) du ressort jusque dans le premier flan (FF1) du ressort.

8. Dispositif selon l'une quelconque des revendications précédentes, dans lequel les arêtes d'encliquetage (RA1, RA2) des barrettes de retenue (RF1, RF2) écartées vers le haut en direction de la zone de tête (HK) et de la face avant (HA) de la réglette de support (HS), s'engagent dans une rainure d'encliquetage (HN1) de la face avant (HA) de la réglette de support (HS)

9. Dispositif selon l'une quelconque des revendications précédentes, dans lequel la lame de ressort (FB) comporte des deux côtés des élargissements (FV) du type en queue de castor.

10. Dispositif selon la revendication 9, selon lequel les largeurs des élargissements (FV) du type en queue de castor de la lame de ressort (FB) correspondent sensiblement aux largeurs des griffes d'encliquetage (RK1, RK2) situées au-dessus en direction de la zone de chapeau (H).
